(19) Europäisches Patentamt

European Patent Office

Office européen des brevets

(11) Publication number: **0 069 308**
**B1**

(12) **EUROPEAN PATENT SPECIFICATION**

(45) Date of publication of patent specification: **27.12.85**

(21) Application number: **82105664.5**

(22) Date of filing: **25.06.82**

(51) Int. Cl.⁴: **H 01 L 29/743,** H 01 L 31/10, H 01 L 29/60

(54) **Thyristor.**

(30) Priority: **30.06.81 JP 101594/81**
**30.06.81 JP 101575/81**

(43) Date of publication of application:
**12.01.83 Bulletin 83/02**

(45) Publication of the grant of the patent:
**27.12.85 Bulletin 85/52**

(84) Designated Contracting States:
**CH DE FR GB LI SE**

(56) References cited:
**DE-A-2 458 401**
**US-A-3 896 476**
**US-A-4 012 761**
**US-A-4 060 825**
**US-A-4 240 091**
**US-A-4 261 001**

(73) Proprietor: **Kabushiki Kaisha Toshiba**
**72, Horikawa-cho Saiwai-ku**
**Kawasaki-shi Kanagawa-ken 210 (JP)**

(72) Inventor: **Ohashi, Hiromichi**
**3016-1, Nagatsuta Midori-ku**
**Yokohama-shi (JP)**
Inventor: **Yamaguchi, Yoshihiro**
**5-7-5, Tsuji Urawa-shi**
**Saitama-ken (JP)**

(74) Representative: **Henkel, Feiler, Hänzel & Partner**
**Möhlstrasse 37**
**D-8000 München 80 (DE)**

Courier Press, Leamington Spa, England.

## Description

The present invention relates to thyristors, and more particularly to an improved thyristor structure which greatly improves photosensitivity, yet still prevents the critical rate of rise of off-state voltage dv/dt from being exceeded.

p- and n-type layers are alternately formed in a four-layered semiconductor crystal structure. Generally, the four layers consist of a p-type emitter layer, an n-type base layer, a p-type base layer and an n-type emitter layer. An anode electrode is deposited on the p-type emitter layer which is the lowermost layer. A cathode electrode is deposited on the n-type emitter layer which is the uppermost layer. A gate electrode is deposited on the upper surface part of the p-type base layer adjacent to the cathode electrode. In the thyristor having the above configuration, when a trigger signal is applied to the gate electrode of the p-type base layer, a small area near the gate electrode is rendered conductive. This area expands to the entire area of the junction of the thyristor over time. When the critical rate of rise of on-state current di/dt is great during triggering, the current is concentrated only at a limited conductive area in the vicinity of the gate electrode, resulting in thermal breakdown due to a local temperature increase.

Along with the trend towards thyristors of higher dielectric strength and larger capacitance, a higher critical rate of rise of on-state current di/dt is desired without adversely affecting the thyristor's operation, while still maintaining the value of the gate control current be as small as possible. However, if a higher critical rate of rise of on-state current di/dt is used, the gate control current must generally be increased. A conventional thyristor cannot satisfy the contradictory requirements described above.

If a photothyristor which is triggered by light instead of by the gate current is used, the light energy to be used is limited and a gate drive with a higher current is difficult. Therefore, the critical rate of rise of on-state current di/dt cannot be increased.

It is strongly desired that a thyristor of high dielectric strength and large capacitance be developed which achieves an improved gate sensitivity without impairing the ability of the thyristor to operate accurately with respect to the critical rate of rise of on-state current di/dt.

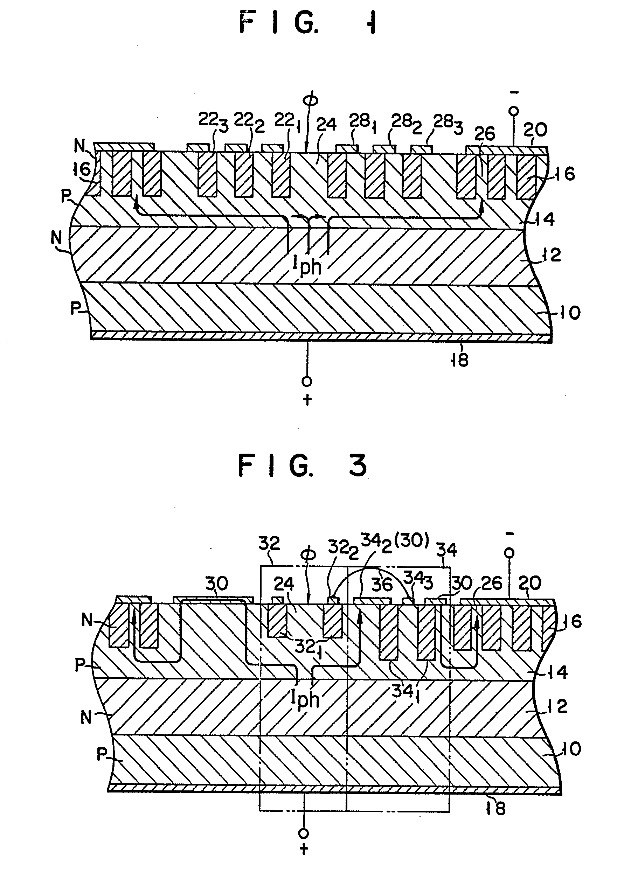

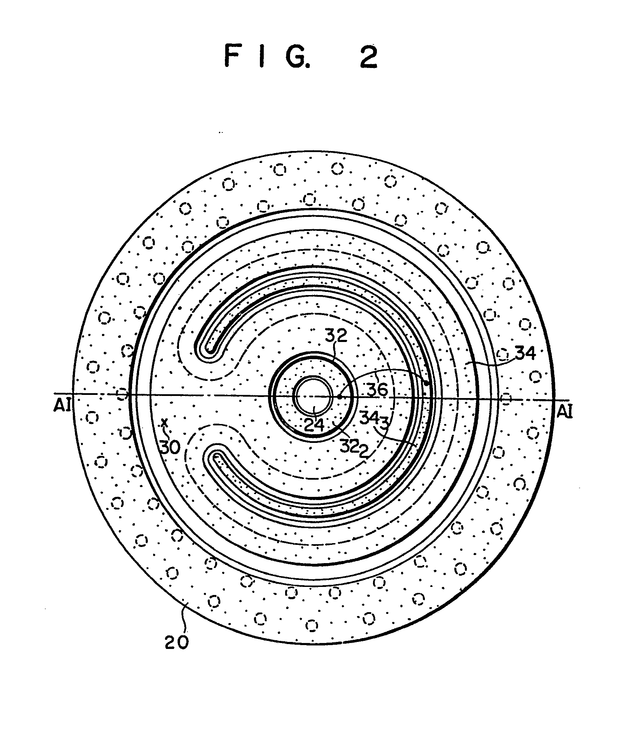

Referring to Fig. 1, a prior art thyristor comprises a p-type emitter layer 10, an n-type base layer 12, a p-type base layer 14 and an n-type emitter layer 16 which is formed in an annular shape when viewed from the top outside the p-type base layer 14. An anode electrode 18 is deposited on one surface of the p-type emitter layer 10. A cathode electrode 20 is deposited on the upper surface of the n-type emitter layer 16. A plurality of pilot thyristors comprise the p-type base layer 14, the n-type base layer 12, the p-type emitter layer 10, and n-type emitter layers $22_1$, $22_2$ and $22_3$ concentrically disposed at equal intervals.

A light-receiving portion 24 is formed at the center of the pilot thyristors.

If an optical trigger signal $\phi$ is radiated on the light-receiving portion of the thyristor with the above arrangement, an photocurrent Iph flows in the p-type base layer 14 transversely. This current flows into the cathode electrode 20 through a short-circuiting portion 26 disposed in the n-type emitter layer 16. A transverse potential difference established in the p-type base layer 14 due to the photocurrent Iph forward-biases the n-type emitter layers $22_1$, $22_2$ and $22_3$ of the pilot thyristors. When the voltage of the light-receiving portion 24 almost reaches the built-in potential of the junction formed between the p-type base layer 14 and the n-type emitter layer $22_1$, electron emission from the n-type emitter layer $22_1$ to the p-type base layer 14 is increased abruptly. As a result, the pilot thyristor near the light-receiving portion 24 is rendered conductive first. This turn-on (conduction) current flows into the second pilot thyristor through an electrode $28_1$. The turn-on current, as the higher gate drive current, causes the second pilot thyristor to turn on and conduct. Similarly, the turn-on current of the pilot thyristor then flows to the third pilot thyristor through an electrode $28_2$. As a result, the third pilot thyristor is rendered conductive. Further, the turn-on current of the third pilot thyristor flows into the main thyristor through the electrode $28_3$ to turn it on.

The current concentration which occurred in the initial turn-on period is dispersed by the plurality of pilot thyristors, preventing the occurence of hot spots and improving the critical rate of rise of the on-state current di/dt.

However, in the thyristor having the multilayered amplification gate structure, the following drawbacks are presented. First, if the transverse potential difference of the p-type base layer 14 of the first pilot thyristor is increased, photosensitivity (gate sensitivity) is increased, but the gate tends to be erroneously turned on by voltage noise from the main thyristor. More particularly, if surge voltage noise is applied between the anode electrode 18 and the cathode electrode 20, a displacement current flows in the same route as the photocurrent Iph. As a result, the thyristor tends to be erroneously turned on. In other words, the critical rate of rise of off-state voltage dv/dt is the maximum rate of rise allowed which will not cause the thyristor to turn on, taking into account any voltage noise present and will hereinafter be referred to as the critical rate of rise of off-state voltage dv/dt.

More particularly, a radius R of the n-type emitter layer $22_1$ of the first pilot thyristor is decreased to limit the displacement current which may be generated in the n-type emitter layer $22_1$. Thus, the photosensitivity of the thyristor is improved, without reducing the critical rate of rise of off-state voltage dv/dt.

Secondly, if the number of pilot thyristors is increased, the later stage pilot thyristors and the main thyristor tend to be erroneously turned on due to voltage noise. This second drawback is more important than the first drawback. Since the displacement current flows over the entire junction area unlike the photocurrent Iph, the displacement current is increased toward the short-circuiting portion 26 of the n-type emitter layer 16 of the main thyristor.

Thirdly, if the number of pilot thyristors is increased, the minimum anode voltage for turning on the pilot thyristors, that is, the finger voltage is generally increased. When thyristors having large finger voltages are operated in parallel to each other, the ON voltage of the first thyristor which first turns on determines the respective anode voltages applied to the following thyristors. As a result, the remaining thyristors which have higher finger voltages than those of the conducted thyristors are not turned on.

The above drawbacks are also found in electrically triggered thyristors in addition to the photothyristors.

It is, therefore, an object of the present invention to provide a thyristor having an improved gate sensitivity (photosensitivity) while still preventing the critical rate of rise of off-state voltage dv/dt from being reduced.

It is another object of the present invention to provide a thyristor which allows free arrangement of pilot thyristors, while still allowing the thyristor to operate properly by preventing the critical rate of rise of off-state voltage dv/dt from being exceeded.

It is still another object of the present invention to provide a thyristor having an alignment between the light-receiving portion and the optical triggering system.

It is yet another object of the present invention to provide a thyristor having a decreased finger voltage.

It is yet still another object of the present invention to provide a thyristor having improved turn-on characteristics.

It is a further object of the present invention to provide a thyristor having an improved critical rate of rise of on-state current di/dt.

These and other objects may be attained by the thyristor of the present invention, according to the claims, and which comprises: a four-layered main thyristor consisting of a first emitter layer, a first base layer, a second base layer and a second emitter layer which have alternate conductivity types and are alternately formed; a collecting electrode deposited on a surface part of the second base layer adjacent to the second emitter layer of the main thyristor to absorb unnecessary displacement current generated in the second base layer; and a plurality of pilot thyristors disposed in the collecting electrode, the plurality of pilot thyristors having, in the second base layer, a plurality of third emitter layers which have the same conductivity type as the second emitter layer and which are formed separately from the second emitter layer so that the plurality of pilot thyristors commonly use the first emitter layer, the first base layer and the second base layer with the main thyristor, the plurality of pilot thyristors each having a gate electrode formed on the second base layer surrounded by the third emitter layer, the gate electrodes being connected to emitter electrodes on the third emitter layers of the pilot thyristors of previous stages, and the emitter electrode of the pilot thyristor of the final stage being commonly used with the collecting electrode, whereby the turn-on current of the pilot thyristor of the final stage of the plurality of pilot thyristor is supplied as a gate current from the collecting electrode to said main thyristor.

According to the present invention, since the collecting electrode is arranged to absorb the displacement current, the displacement current influences the thyristor of the present invention much less than in the conventional thyristor. Therefore, the gate sensitivity is greatly improved without impairing the ability of thyristor to operate below the critical rate of rise of off-state voltage dv/dt. The displacement current is controlled, regardless of the number and arrangement of the stages of the pilot thyristors surrounded by the collecting electrode. Therefore, the thyristor according to the present invention can be readily designed to control the ability of the thyristor to operate below the critical rate of rise of off-state voltage dv/dt. If the present invention is applied to a photothyristor, the radius of the light-receiving portion can be increased, and alignment between the light-receiving portion and the optical triggering system is improved. Further, since the width of the second base layer of the pilot thyristor can differ from those of other layers, the maximum turn-on current of the first pilot thyristor is greatly decreased, resulting in a decreased number of pilot thyristors and a reduction of the finger voltage. With the above arrangement, the turn-on characteristics are also improved. Further, since the thyristor according to the present invention has a structure having the collecting electrode and the plurality of pilot thyristors, the critical rate of rise of on-state current di/dt is greatly improved.

By way of example and to make the description clearer, reference is made to the accompanying drawings in which:

Fig. 1 is a schematic sectional view of a conventional photothyristor;

Fig. 2 is a schematic plan view showing the electrode arrangement of a thyristor according to a first embodiment of the present invention;

Fig. 3 is a schematic sectional view of the thyristor shown in Fig. 2;

Fig. 4 is a graph for explaining the maximum turn-on current of a first pilot thyristor of the thyristor shown in Fig. 2 as a function of the number of stages thereof as compared with the maximum turn-on current of the conventional thyristor as a function of the number of stages thereof;

Fig. 5 is a schematic plan view of a thyristor according to a second embodiment of the present invention; and

Fig. 6 is a schematic sectional view of the thyristor shown in Fig. 5.

A thyristor according to a first embodiment of the present invention will be described with reference to the accompanying drawings.

Fig. 2 is a schematic plan view showing an electrode arrangement of the thyristor according to the first embodiment of the present invention. Fig. 3 is a schematic sectional view of the thyristor taken along the line AI—AI in Fig. 2. The same reference numerals as in Fig. 1 denote the same parts in Figs. 2 and 3.

A collecting electrode 30 is deposited on a p-type base layer 14 among the four semiconductor layers which constitute the thyristor. First and second pilot thyristors 32 and 34 are surrounded by the collecting electrode 30. An n-type emitter layer $32_1$, concentric with the light-receiving portion 24, is formed in the first pilot thyristor 32. A cathode electrode $32_2$ is deposited on the n-type emitter layer $32_1$. As shown in Fig. 2, the second pilot thyristor 34 is formed so as to surround the first pilot thyristor 32 in a horse shoe shape. The second pilot thyristor 34 comprises double n-type emitter layers $34_1$ surrounded by the collecting electrode 30, an emitter electrode $34_2$ formed on the n-type emitter layer $34_1$ and a gate electrode $34_3$ formed on the p-type base layer 14. The emitter electrode $34_2$ and the collecting electrode 30 are used commonly. The gate electrode $34_3$ of the second pilot thyristor 34 is electrically connected to the cathode electrode $32_2$ of the first pilot thyristor 32 through a conductor 36 such as an aluminum wire. Therefore, the turn-on current of the first pilot thyristor 32 is supplied as the gate current of the second pilot thyristor 34. The depth of the n-type emitter layer $34_1$ of the second pilot thyristor 34 is deeper than that of the n-type emitter layer $32_1$ of the first pilot thyristor 32 so that the width of the p-type layer 14 of the second pilot thyristor 34 is smaller than that of the p-type base layer 14 of the first pilot thyristor 32.

If an optical trigger signal $\phi$ is radiated on the light-receiving portion 24 of the thyristor with the above arrangement, the photocurrent Iph is generated in a central depletion layer. The photocurrent Iph then flows into the p-type base layer 14. The flow-in current is collected in the collecting electrode 30 formed on the p-type base layer 14 as indicated by the arrow in Fig. 3. Thereafter, the photocurrent Iph flows into the cathode electrode 20 through the p-type base layer 14 and the short-circuiting portion 26. At this time, since the photocurrent Iph flows transversely in the p-type base layer 14 immediately below the first pilot thyristor 32, the n-type emitter layer $32_1$ of the first pilot thyristor 32 is forward-biased by the transverse potential difference in the p-type base layer. When the deepest potential in the forward bias almost reaches the built-in potential of the junction between the n-type emitter layer $32_1$ and the

p-type base layer 14, electron injection from the n-type emitter layer $32_1$ to the p-type base layer 14 increases to turn on the first pilot thyristor 32.

A turn-on current Ip1 of the first pilot thyristor 32 is supplied as the higher gate drive current to the gate electrode $34_3$ of the second pilot thyristor 34 through the conductor 36 to turn on the second pilot thyristor 34. A turn-on current ip2 of the second pilot thyristor 34 flows through the collecting electrode 30 and the short-circuiting portion 26 and is supplied to the cathode electrode 20. This turn-on current ip2 serves as the gate current of the main thyristor to turn on the main thyristor.

With the above arrangement, the width of the p-type base layer 14 of the second pilot thyristor 34 is narrower than that of the p-type base layer 14 of the first pilot thyristor 32. The p-type base width directly influences the turn-on duration of the thyristor. If the width of the p-type base layer is narrower, the turn-on duration is generally short. When the second pilot thyristor 34 is turned on by the turn-on current ip1 of the first pilot thyristor 32, the turn-on current of the second pilot thyristor is abruptly increased. As a result, only a small amount of current is required to be output from the first pilot thyristor 32. Since the width of the base layer of the second pilot thyristor 34 is small, sharp turn-on operation is performed. Therefore, the turn-on characteristics of the group of pilot thyristors are improved greatly as compared with the conventional thyristor arrangement in which all the base layers have the same width.

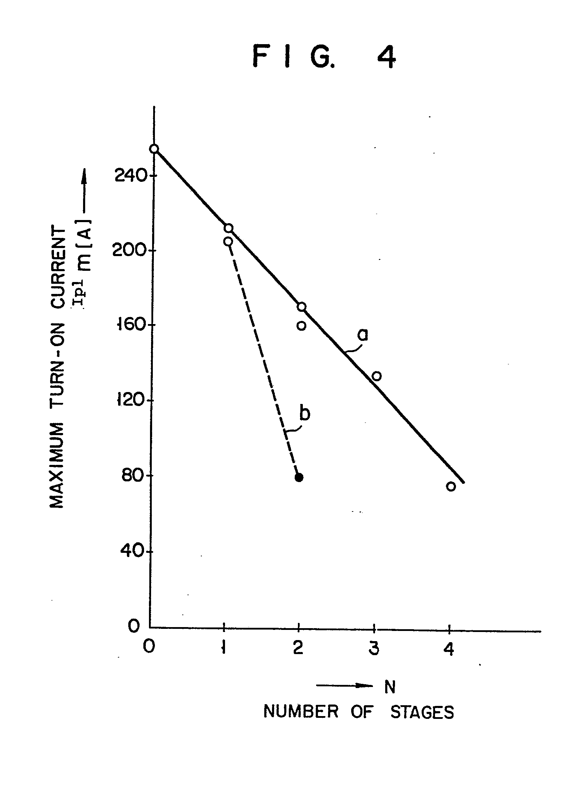

Fig. 4 is a graph for explaining the number N of stages of pilot thyristors as a function of maximum turn-on current Iplm of the first pilot thyristor, where N=0 indicates a conventional thyristor without having pilot thyristors. Line a indicates the electrical characteristics of the conventional thyristor shown in Fig. 1, while line b indicates the electrical characteristics of the thyristor according to the present invention.

As is apparent from the graph, along with an increase in the number N of stages of thyristors, the maximum turn-on current of the first stage is linearly decreased, so far as the conventional structure in which all widths of the p-type base layers of the pilot thyristors are the same is concerned. However, according to the arrangement of the thyristor of the present invention, the maximum turn-on current Iplm can be reduced into half or less with the two stage structure. Assume that the maximum turn-on current Iplm is to be as 80 A. Then, a four-stage arrangement must be utilized in the conventional thyristor arrangement.

According to the present invention, the first pilot thyristor 32 produces only a small current without requiring an increase in the number of stages of pilot thyristors. Since the radius R of the first pilot thyristor 32 is decreased and the displacement current is effectively controlled, the ability of the thyristor to operate below the critical rate of rise of off-state voltage dv/dt is not impaired and the gate sensitivity (photosensitivity) is greatly improved. Further, according to the present invention, since the number N of stages of the pilot thyristors can be decreased, the finger voltage can also be decreased.

The second pilot thyristor 34 does not completely encompass the first pilot thyristor 32, so that the displacement current developed in the first pilot thyristor 32 need not be considered in designing the second pilot thyristor 34. Therefore, the pilot thyristors can be arranged freely and the operating characteristics of the thyristor with respect to the critical rate of rise of off-state voltage dv/dt can be readily controlled. Since the width and length of the n-type emitter layer $34_1$ of the second pilot thyristor 34 are determined to be sufficiently large, the initial turn-on region can be sufficiently large. Although a relatively large current is required to be generated from the second pilot thyristor 34, the turn on characteristics of the device with regard to the critical rate of rise of on-state current di/dt are not lowered.

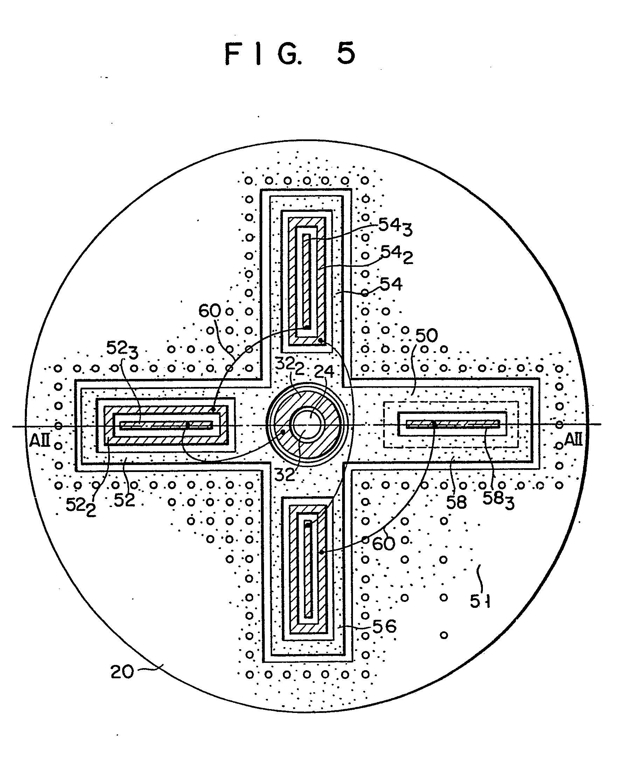

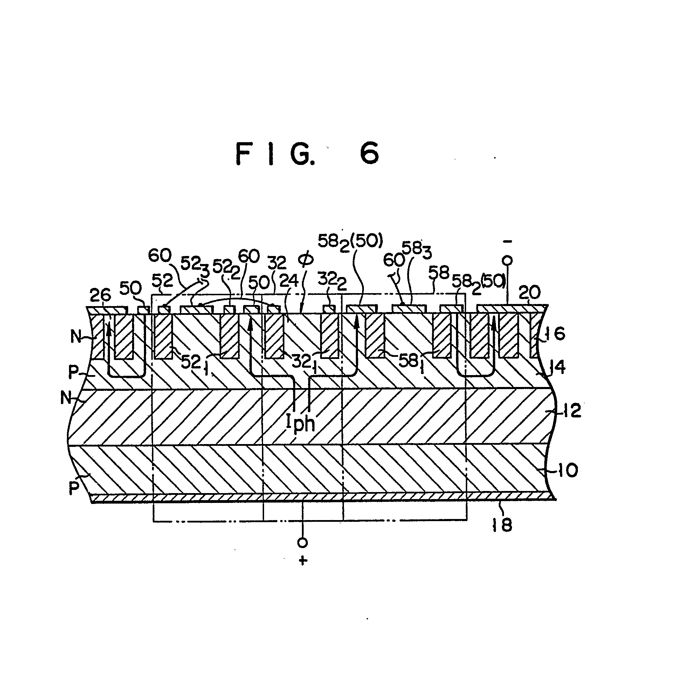

Fig. 5 is a schematic plan view showing the electrode arrangement of a thyristor according to a second embodiment of the present invention. Fig. 6 is a schematic sectional view of the thyristor taken along the line AII—AII in Fig. 5. The same reference numerals as in Fig. 1 denote the same parts in Figs. 5 and 6.

A collecting electrode 50 is deposited on the upper surface part of the p-type base layer 14 adjacent to the n-type emitter layer 16 of the main thyristor comprising the p-type emitter layer 10, the n-type base layer 12, the p-type base layer 14 and the n-type emitter layer 16. A plurality of pilot thyristors (5 in the second embodiments) are surrounded by the collecting electrode 50. A main thyristor 51 is formed at the outer periphery of the collecting electrode 50, that is, the peripheries of the pilot thyristors. More particularly, the first pilot thyristor 32 has the n-type emitter layer $32_1$ which has an annular shape when viewed from the top and which surrounds the light-receiving portion 24. The cathode electrode $32_2$ is deposited on the upper surface of the n-type emitter layer $32_1$. Second to fifth pilot thyristors 52, 54, 56 and 58 comprise n-type emitter layers $52_1$, $54_1$, $56_1$, and $58_1$ surrounded by the collecting electrode 50 formed in the p-type base layer 14, emitter electrodes $52_2$, $54_2$, $56_2$ and $58_2$ respectively deposited on the n-type emitter layers $52_1$, $54_1$, $56_1$ and $58_1$, and gate electrodes $52_3$, $54_3$, $56_3$ and $58_3$ deposited on the p-type base electrodes, respectively. The emitter electrode $58_2$ of the fifth pilot thyristor 58 is used commonly with the collecting electrode 50. The gate electrodes $52_3$, $54_3$, $56_3$ and $58_3$ are subsequently electrically connected to the emitter electrodes $52_2$, $54_2$, $56_2$ and $58_2$ through a metal layer 60 such as an aluminum wire, respectively. Therefore, the pilot thyristors 52, 54, 56 and 58 receive the turn-on currents as the gate currents which are output from the thyristors of the immediately preceding stages, respectively. These thyristors 52 through 58 are then sequentially turned on. The main thyristor 51 receives the turn-on current of the fifth pilot thyristor 58 through the collecting electrode 50 and is rendered conductive. The connections of the pilot thyristors 52 through 58 are not particularly limited.

When the optical gate signal φ is radiated on the light-receiving portion 24 of the thyristor of the above arrangement, the photocurrent Iph generated in a central junction depletion region of the first pilot thyristor 32 flows into the p-type base layer 14. This photocurrent Iph flows transversely in the p-type base layer 14 and collected in the collecting electrode 50 disposed in the p-type base layer. Thereafter, the photocurrent Iph flows into the cathode electrode 20 through the p-type base layer 14 and the short-circuiting portion 26. As a result, a transverse potential difference in the p-type base layer 14 of the first pilot thyristor 32 is established due to the photocurrent Iph. The n-type emitter layer $32_1$ of the first pilot thyristor 32 is forward-biased. When the deepest potential of the forward-bias voltage almost reaches the junction built-in potential between the n-type emitter layer $32_1$ and the p-type base layer 14, electron injection from the n-type emitter layer $32_1$ to the p-type base layer 14 is increased abruptly. Therefore, the first pilot thyristor 32 is turned on beginning with the junction between the n-type emitter layer $32_1$ and the p-type base layer 14.

The turn-on current of the first pilot thyristor 32 is supplied as the gate current to the gate electrode $52_3$ of the second pilot thyristor 52 through the metal layer 60. The second pilot thyristor 52 is then turned on. Similarly, the turn-on current of the second pilot thyristor 52 is supplied to the third pilot thyristor 54 which is, in turn, turned on. The fourth and fifth pilot thyristors 56 and 58 are sequentially turned on in the same manner as the third thyristor. Further, the turn-on current of the fifth pilot thyristor 58 flows into the cathode electrode 20 through the collecting electrode 50 and the short-circuiting portion 26. This turn-on current serves as the gate current of the main thyristor 51, so that the main thyristor 51 is turned on.

With the above mode of operation, if voltage noise having a large critical rate of rise of off-state voltage dv/dt is applied between the anode and the cathode, the displacement current generated in the p-type base layer 14 is collected to the collecting electrode 50 which surrounds the pilot thyristors 32, 52, 54, 56 and 58 and flows into the cathode electrode 20 through the p-type base layer 14 and the short-circuiting portion 26. Therefore, according to the thyristor of the second embodiment of the present invention, influence of the displacement current which has been a drawback in the conventional thyristor can be eliminated. Further, the displacement current can be controlled regardless of the arrangement of the pilot thyristors. Even if the number of stages of the pilot thyristors is increased, the thyristor's ability to operate below the critical rate of rise of off-state voltage dv/dt of the final stage of pilot thyristors and the main thyristor is not lowered.

The maximum turn-on current Iplm of the first pilot thyristor 32 is linearly decreased with an increase in the number N of stages, as indicated by line $a$ in Fig. 4. The power concentration on the first pilot thyristor 32 is prevented by increasing the number N of stages. The radius R is decreased and the displacement current generated in this region is controlled, so that a large resistance can be set in the p-type base layer 14 immediately below the n-type emitter layer of the first pilot thyristor 32. As a result, the gate sensitivity (photosensitivity) can be improved without impairing the thyristor's operating characteristics with respect to the critical rate of rise of off-state voltage dv/dt. For example, the gate sensitivity can be as high as 2 to 3 mW. Further, the ability of the thyristor to operate below the critical rate of rise of on-state current di/dt is improved two to three times that of the conventional thyristor.

According to the present invention, the gate sensitivitiy (photosensitivity) is improved greatly without impairing essential characteristics of the thyristor such as the thyristor's ability to operate below the critical rate of rise of off-state voltage dv/dt and the critical rate of rise of on-state current di/dt.

The present invention is not limited to the particular embodiments and various changes and modifications may be made within the scope of the present invention. For example, in the first and second embodiments, the present invention is applied to the photothyristor. However, the present invention may be applied to an electrically triggered thyristor which has a gate electrode in the light-receiving portion 24. Further, pilot thyristors need only be arranged to be surrounded by the collecting electrode formed in the base layer so as to sequentially electrically connect the pilot thyristors. Therefore, the number of stages as shown in the first and second embodiments may be arbitrarily changed as needed in accordance with design specifications.

**Claims**

1. A thyristor having: a four-layered main thyristor consisting of a first emitter layer, a first base layer, a second base layer and a second emitter layer which have alternate conductivity types and are alternately layered; and a plurality of pilot thyristors which use first emitter layer, first base layer and second base layer commonly with said main thyristor by forming in said second base layer, separately from said second emitter layer, a plurality of third emitter layers whose conductivity type is the same as the conductivity type of said second emitter layer; characterized in that said thyristor comprises

a collecting electrode (30) deposited on a surface part of said second base layer (14) adjacent to said second emitter layer (16) of said main thyristor to absorb an unnecessary displacement current generated in said second base layer; and

said plurality of pilot thyristors (32, 34) disposed inside said collecting electrode, said plurality of pilot thyristors (32, 34) each having a gate electrode ($34_3$) formed on said second base layer (14) surrounded by said third emitter layer ($34_1$), said gate electrodes ($34_3$) being respectively connected to emitter electrodes ($32_2$) formed on said third emitter layers ($32_1$) of said pilot thyristors of previous stages, and said emitter electrode ($34_2$) of said pilot thyristor of the final stage being commonly used with said collecting electrode (30);

whereby a turn-on current of said pilot thyristor (34) of the final stage is supplied as a gate current from said collecting electrode (30) to said main thyristor.

2. A thyristor according to claim 1, characterized in that at least one of said plurality of pilot thyristors (32, 34) has a second base layer (14) of a width different from the widths of said second base layers (14) of other pilot thyristors (32, 34).

3. A thyristor according to claim 2, characterized in that the width of said second base layer (14) of said pilot thyristor (32) of a first stage of said plurality of pilot thyristors (32, 34) is greater than the width of said second base layer (14) of at least one of other pilot thyristors (34).

4. A thyristor according to claim 1, characterized in that said pilot thyristor (32) of the first stage of said plurality of pilot thyristors (32, 34) is turned on in response to an optical trigger signal.

5. A thyristor according to claim 1, characterized in that said third emitter layer ($32_1$, $34_1$) of each of said plurality of pilot thyristors (32, 34) forms a closed loop, each of said gate electrodes ($34_3$) being deposited on the surface part of said second base layer located in said closed loop.

6. A thyristor according to claim 1, characterized in that said collecting electrode (30) has a circular shape and comprises said pilot thyristor (32) of a first stage at the center of said collecting electrode (30) and at least an other pilot thyristor (34) having a horse shoe shape and surrounding said first pilot thyristor (32).

7. A thyristor according to claim 1, characterized in that said collecting electrode (50) has a cross shape and includes said first pilot thyristor (32) of the first stage at the center of said collecting electrode (50) and at least another pilot thyristor (52, 54, 56, 58) disposed at arm portions of the cross of said collecting electrode (50).

**Patentansprüche**

1.  Thyristor mit einem Vierschicht-Hauptthyristor aus einer ersten Emitterschicht, einer ersten Basischicht, einer zweiten Basisschicht und einer zweiten Emitterschicht, die abwechselnde Leitfähigkeitstypen haben und abwechselnd geschichtet sind, und mit mehreren Hilfsthyristoren, die die erste Emitterschicht, die erste Basisschicht und die zweite Basisschicht gemeinsam mit dem Hauptthyristor verwenden, indem sie in der zweiten Basisschicht, getrennt von der zweiten Emitterschicht, mehrere dritte Emitterschichten bilden, deren Leitfähigkeitstyp der gleiche ist wie der Leitfähigkeitstyp der zweiten Emitterschicht, dadurch gekennzeichnet, daß der Thyristor aufweist eine Sammelelektrode (30), die auf einen Oberflächenteil der zweiten Basisschicht (14) neben der zweiten Emitterschicht (16) des Hauptthyristors aufgetragen ist, um einen in der zweiten Basisschicht erzeugten unnötigen Verschiebungsstrom zu absorbieren, und die mehreren Hilfsthyristoren (32, 34), die innerhalb der Sammelelektrode angeordnet sind, wobei die mehreren Hilfsthyristoren (32, 34) jeweils eine Steuerelektrode ($34_3$) aufweisen, die auf der Basisschicht (14) ausgeführt ist, welche durch die dritte Emitterschicht ($34_1$) umgeben ist, wobei die Steuerelektroden ($34_3$) jeweils mit Emitterelektroden ($32_2$) verbunden sind, die auf den dritten Emitterschichten ($32_1$) der Hilfsthyristoren vorhergehender Stufen ausgeführt sind, und wobei die Emitterelektrode ($34_2$) des Hilfsthyristors der letzten Stufe gemeinsam mit der Sammelelektrode (30) verwendbar ist, wodurch ein Einschaltstrom des Hilfsthyristors (34) der letzten Stufe als Steuerstrom von der Sammelelektrode (30) zum Hauptthyristor speisbar ist.

2. Thyristor nach Anspruch 1, dadurch gekennzeichnet, daß wenigstens einer der mehreren Hilfsthyristoren (32, 34) eine zweite Basisschicht (14) einer von den Breiten der zweiten Basisschichten (14) der anderen Hilfsthyristoren (32, 34) verschiedenen Breite aufweist.

3. Thyristor nach Anspruch 2, dadurch gekennzeichnet, daß die Breite der Basisschicht (14) des Hilfsthyristors (32) einer ersten Stufe der mehreren Hilfsthyristoren (32, 34) größer als die Breite der zweiten Basisschicht (14) wenigstens eines anderen Hilfsthyristors (34) ist.

4. Thyristor nach Anspruch 1, dadurch gekennzeichnet, daß der Hilfsthyristor (32) der ersten Stufe der mehreren Hilfsthyristoren (32, 34) abhängig von einem optischen Steuersignal einschaltbar ist.

5. Thyristor nach Anspruch 1, dadurch gekennzeichnet, daß die dritte Emitterschicht ($32_1$, $34_1$) jedes der mehreren Hilfsthyristoren (32, 34) eine geschlossene Schleife bildet, wobei jede Steuerelektrode ($34_3$) auf dem in der geschlossenen Schleife liegenden Oberflächenteil der zweiten Basisschicht aufgetragen ist.

6. Thyristor nach Anspruch 1, dadurch gekennzeichnet, daß die Sammelelektrode (30) eine kreisförmige Gestalt hat und den Hilfsthyristor (32) einer ersten Stufe in der Mitte der Sammelelektrode (30) sowie wenigstens einen anderen Hilfsthyristor (34) aufweist, der Hufeisenform hat und den ersten Hilfsthyristor (32) umgibt.

7. Thyristor nach Anspruch 1, dadurch gekennzeichnet, daß die Sammelelektrode (50) eine kreuzförmige Gestalt hat und den ersten Hilfsthyristor (32) der ersten Stufe in der Mitte der Sammelelektrode (50) sowie einen anderen Hilfsthyristor (52, 54, 56, 58) aufweist, der an Armteilen des Kreuzes der Sammelelektrode (50) angeordnet ist.

## Revendications

1. Thyristor, comportant: un thyristor principal à quatre couches consistant en une première couche d'émetteur, une première couche de base, une seconde couche de base et une seconde couche d'émetteur ayant des types de conductibilité alternés et superposés alternativement; et plusieurs thyristors pilotes utilisant la première couche d'émetteur, la première couche de base et la seconde couche de base en commun avec ledit thyristor principal en formant dans ladite seconde couche de base, séparément de ladite seconde couche d'émetteur, plusieurs troisièmes couches d'émetteur dont le type de conductivité est le même que celui de ladite seconde couche d'émetteur; caractérisé en ce que ledit thyristor comporte: une électrode collectrice (30) déposée sur une partie de surface de ladite seconde couche de base (14) près de ladite seconde couche d'émetteur (16) dudit thyristor principal pour absorber un courant de déplacement inutile développé dans ladite seconde couche de base, et lesdits plusieurs thyristors pilotes (32, 34) disposés à l'intérieur de ladite électrode collectrice, lesdits plusieurs thyristors pilotes (32, 34) comprenant chacun une électrode de grille ($34_3$) formée sur ladite seconde couche de base (14) entourée par ladite troisième couche d'émetteur ($34_1$), lesdites électrodes de grille ($34_3$) étant connectées respectivement aux électrodes d'émetteur ($32_2$) formées sur lesdites troisièmes couches d'émetteur ($32_1$) desdits thyristors pilotes des étages précédents et ladite électrode d'émetteur ($34_2$) dudit thyristor pilote de l'étage final étant utilisée en commun avec ladite électrode collectrice (30); de manière qu'un courant au déblocage dudit thyristor pilote (34) de l'étage final soit fourni comme un courant de grille par ladite électrode collectrice (30) audit thyristor principal.

2. Thyristor selon la revendication 1, caractérisé en ce que l'un au moins desdits plusieurs thyristors pilotes (32, 34) comporte une seconde couche de base (14) d'une largeur différente des largeurs desdites secondes couches de base (14) des autres thyristors pilotes (32, 34).

3. Thyristor selon la revendication 2, caractérisé en ce que la largeur de ladite seconde couche de base (14) dudit thyristor pilote (32) d'un premier étage desdits plusieurs thyristors pilotes (32, 34) est supérieure à la largeur de ladite seconde couche de base (14) de l'un au moins des autres thyristors pilotes (34).

4. Thyristor selon la revendication 1, caractérisé en ce que ledit thyristor pilote (32) du premier étage desdits plusieurs thyristors pilotes (32, 34) est débloqué en réponse à un signal de déclenchement optique.

5. Thyristor selon la revendication 1, caractérisé en ce que ladite troisième couche d'émetteur ($32_1$,

$34_1$) de chacun desdits plusieurs thyristors pilotes (32, 34) forme une boucle fermée, chacune desdites électrodes de grille ($34_3$) étant déposée sur la partie de surface de ladite seconde couche de base située dans ladite boucle fermée.

6. Thyristor selon la revendication 1, caractérisé en ce que ladite électrode collectrice (30) a une forme circulaire et comprend ledit thyristor pilote (32) d'un premier étage au centre de ladite électrode collectrice (30) et au moins un autre thyristor pilote (34) ayant une forme en fer à cheval et entourant ledit premier thyristor pilote 32.

7. Thyristor selon la revendication 1, caractérisé en ce que ladite électrode collectrice (50) a une forme de croix et contient ledit premier thyristor pilote (32) du premier étage au centre de ladite électrode collectrice (50) et au moins un autre thyristor pilote (52, 54, 56, 58) disposé dans des parties de bras de la croix de ladite électrode collectrice (50).

# F I G. 1

# F I G. 3

# F I G. 2

0 069 308

F I G. 4

3

# F I G. 5

# F I G. 6